(19) Europäisches Patentamt / European Patent Office / Office européen des brevets

(11) **EP 4 429 445 B1**

(12) **EUROPEAN PATENT SPECIFICATION**

(45) Date of publication and mention
of the grant of the patent:
**15.04.2026   Bulletin 2026/16**

(21) Application number: **24161672.1**

(22) Date of filing: **06.03.2024**

(51) International Patent Classification (IPC):
**H10N 30/20** *(2023.01)*      **H10N 30/853** *(2023.01)*
**B41J 2/14** *(2006.01)*

(52) Cooperative Patent Classification (CPC):
**H10N 30/2047; B41J 2/14233; B41J 2/161;
B41J 2/1623; B41J 2/1628; B41J 2/1629;
B41J 2/1635; B41J 2/1642; B41J 2/1646;
H10N 30/706; H10N 30/708; H10N 30/8542;**
B41J 2002/14419; B41J 2002/14491; B41J 2202/03;
(Cont.)

(54) **PIEZOELECTRIC ELEMENT APPLICATION DEVICE**

ANWENDUNGSVORRICHTUNG MIT PIEZOELEKTRISCHEM ELEMENT

DISPOSITIF D'APPLICATION D'UN ÉLÉMENT PIÉZOÉLECTRIQUE

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority:   **07.03.2023   JP 2023034524**

(43) Date of publication of application:
**11.09.2024   Bulletin 2024/37**

(73) Proprietor: **Seiko Epson Corporation**
**Tokyo 160-8801 (JP)**

(72) Inventors:
• **ITAYAMA, Yasuhiro**
  **Suwa-shi, 392-8502 (JP)**
• **HORIBA, Yasuhiro**
  **Suwa-shi, 392-8502 (JP)**
• **TAKEUCHI, Masahiro**
  **Suwa-shi, 392-8502 (JP)**

(74) Representative: **Lewis Silkin LLP**
**Arbor**
**255 Blackfriars Road**
**London SE1 9AX (GB)**

(56) References cited:
**JP-A- 2016 192 511      US-A1- 2014 267 504
US-A1- 2016 121 610      US-A1- 2022 097 372
US-A1- 2023 320 218**

(52) Cooperative Patent Classification (CPC): (Cont.)
     H10N 30/078

**Description**

BACKGROUND

1. Technical Field

The present invention relates to a piezoelectric element application device.

2. Related Art

A piezoelectric element generally includes a substrate, a piezoelectric layer having electromechanical conversion characteristics, and two electrodes sandwiching the piezoelectric layer. In recent years, devices (piezoelectric element application devices) using such a piezoelectric element as a drive source have been actively developed. As one of the piezoelectric element application devices, there are a liquid ejecting head represented by an ink-jet type recording head, a MEMS element represented by a piezoelectric MEMS element, an ultrasonic measurement apparatus represented by an ultrasonic sensor, and a piezoelectric actuator apparatus.

Lead zirconate titanate (PZT) is known as a material (piezoelectric material) of the piezoelectric layer of the piezoelectric element. However, in recent years, from a viewpoint of reducing an environmental impact, progress has been made in development of lead-free piezoelectric materials with low lead content.

As one of the lead-free piezoelectric materials, for example, potassium sodium niobate (KNN; $(K,Na)NbO_3$) has been proposed as disclosed as in JP-A-2018-133458.

Specifically, JP-A-2018-133458 discloses a piezoelectric element including a first electrode, a second electrode, and a thin-film piezoelectric layer (KNN-based piezoelectric layer) made of a perovskite-type composite oxide containing potassium, sodium, and niobium and provided between the first electrode and the second electrode. JP-A-2018-133458 discloses a vibration plate including an elastic film made of silicon dioxide formed on a substrate and an insulator film made of zirconium oxide formed on the elastic film. The insulator film made of zirconium oxide disclosed in JP-A-2018-133458 has a function of preventing diffusion of components such as potassium constituting the piezoelectric layer toward the substrate.

JP-A-2018-133458 is an example of the related art.

JP-A-2016-192511 discloses a piezoelectric element that comprises: a zirconium oxide layer formed on a substrate; a first electrode formed on the zirconium oxide layer; a piezoelectric layer composed of a complex oxide of ABO-type perovskite structure formed on the first electrode and containing potassium (K), sodium (Na) and niobium (Nb); and a second electrode formed on the piezoelectric layer. When changes in respective amounts of potassium and sodium are checked in an area extending over the first electrode side interface of the zirconium oxide layer, they are smaller on the substrate side of the interface than on the first electrode side of the interface. A piezoelectric element application device according to the preamble of independent claim 1 is disclosed as well (comparative example 1).

SUMMARY

As described above, a piezoelectric element (KNN-based piezoelectric element) using KNN as one of the lead-free piezoelectric materials has been proposed. However, it is known that a displacement characteristic of the KNN-based piezoelectric layer is smaller than a displacement characteristic of a lead-based piezoelectric layer (for example, a PZT piezoelectric layer) in the related art, and in the piezoelectric element including the elastic film as a part of the substrate and a piezoelectric element application device (piezoelectric device) including the piezoelectric element, a displacement amount of the vibration plate may be reduced by simply replacing the PZT piezoelectric layer with the KNN piezoelectric layer, and required specifications for the piezoelectric device may not be satisfied.

Under such circumstances, there is a demand for a KNN-based piezoelectric element capable of increasing the displacement amount of the vibration plate.

Such a problem is not limited to a piezoelectric actuator mounted on a liquid ejecting head represented by an ink-jet type recording head, and also exists in other piezoelectric element application devices.

In order to solve the above problems, according to the invention, there is provided a piezoelectric element application device as defined in claim 1.

BRIEF DESCRIPTION OF THE DRAWINGS

FIG. 1 is a perspective view showing a schematic configuration of a recording apparatus according to a first embodiment.

FIG. 2 is an exploded perspective view of a recording head of the recording apparatus in FIG. 1.

FIG. 3 is a plan view of the recording head of the recording apparatus in FIG. 1.

FIG. 4 is a cross-sectional view taken along a line A-A' in FIG. 3.

FIG. 5 is an enlarged cross-sectional view taken along a line B-B' in FIG. 4.

FIG. 6 is a diagram showing a measurement result of secondary ion mass spectrometry according to Example 1.

FIG. 7 is a diagram showing a measurement result of secondary ion mass spectrometry according to Example 2.

FIG. 8 is a diagram showing a measurement result of secondary ion mass spectrometry according to Comparative Example 1.

FIG. 9 is a scanning electron microscope (SEM) image according to Comparative Example 2.

FIG. 10 is a diagram showing a measurement result of secondary ion mass spectrometry on a piezoelectric element according to the first embodiment.

DESCRIPTION OF EMBODIMENTS

Hereinafter, an embodiment will be described with reference to the drawings. In the drawings, the same reference numerals denote the same members, and description thereof will be appropriately omitted. Numbers after characters constituting reference numerals are referred to with reference numerals including the same characters, and used for distinguishing elements having similar configurations. When it is not necessary to distinguish elements indicated by reference numerals including the same characters, the elements are referred to with reference numerals including only characters.

In the drawings, X, Y, and Z represent three spatial axes orthogonal to one another. In the present specification, directions along the axes are respectively referred to as a first direction X (X direction), a second direction Y (Y direction), and a third direction Z (Z direction), and a direction of an arrow in the drawings is described as a positive (+) direction, while a direction opposite from the arrow is described as a negative (-) direction. The X direction and the Y direction represent an in-plane direction of a plate, a layer, and a film, and the Z direction represents a thickness direction or a lamination direction of the plate, the layer, and the film.

In addition, components shown in the drawings, that is, a shape and a size of each portion, thicknesses of a plate, a layer, and a film, a relative positional relationship, a repeating unit, and the like may be exaggeratedly shown for describing the disclosure. Further, the term "above" in the present specification does not limit a positional relationship of components to "directly above". For example, expressions such as "a first electrode on a substrate" and "a piezoelectric layer on the first electrode" to be described later do not exclude a fact that another element is provided between the substrate and the first electrode or between the first electrode and the piezoelectric layer.

First Embodiment

PIEZOELECTRIC ELEMENT APPLICATION DEVICE

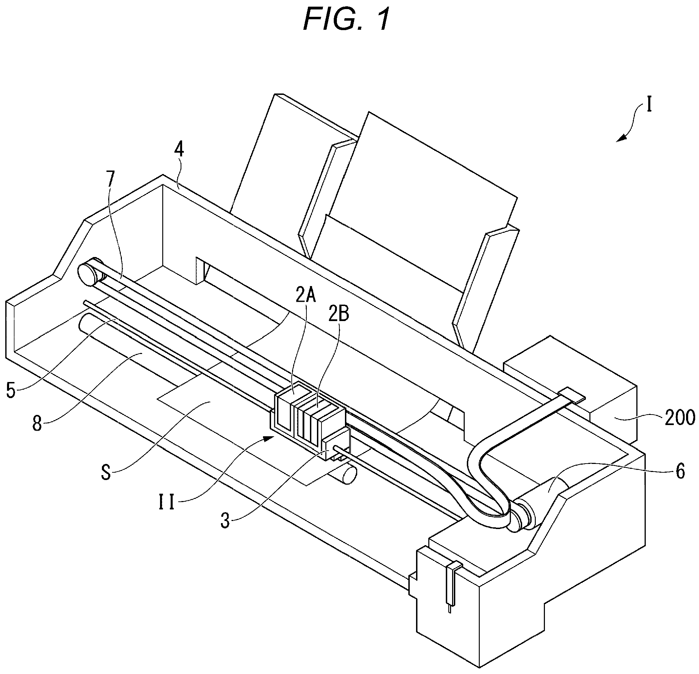

First, an ink-jet type recording apparatus as an example of a liquid ejecting apparatus including a recording head as an example of a piezoelectric element application device according to a first embodiment of the disclosure will be described with reference to the drawings. FIG. 1 is a perspective view showing a schematic configuration of an ink-jet type recording apparatus.

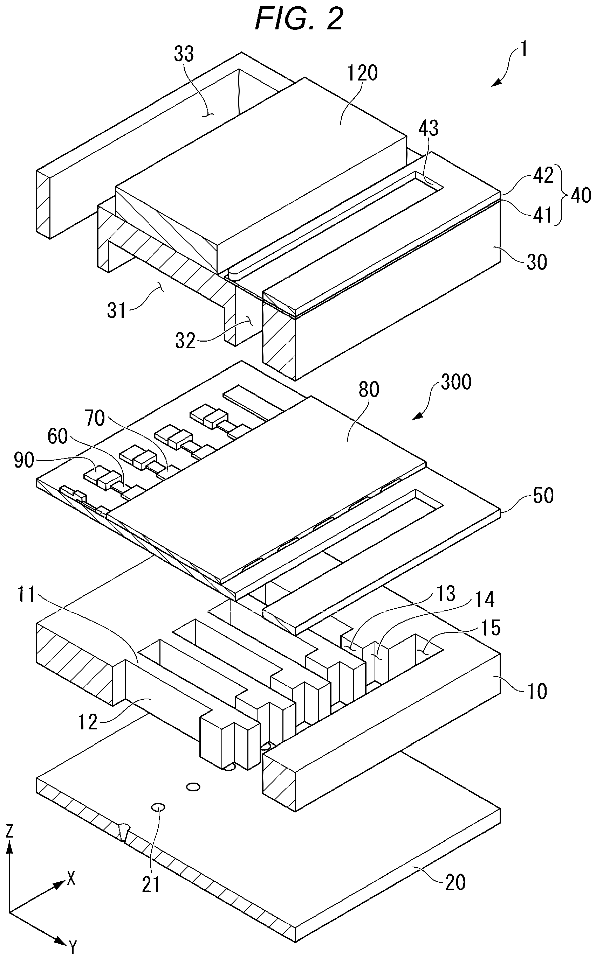

In an ink-jet type recording apparatus (recording apparatus) I, as shown in FIG. 1, an ink-jet type recording head unit (head unit) II is detachably attached to cartridges 2A and 2B. The cartridges 2A and 2B constitute an ink supply unit. The head unit II includes a plurality of ink-jet type recording heads (recording heads) 1 to be described later (see FIG. 2 and the like), and is mounted on a carriage 3. The carriage 3 is provided on a carriage shaft 5 attached to an apparatus main body 4 so as to be movable in an axial direction. The head unit II and the carriage 3 can discharge, for example, a black ink composition and a color ink composition, respectively.

A driving force of a driving motor 6 is transmitted to the carriage 3 via a plurality of gears (not shown) and a timing belt 7, and the carriage 3 on which the head unit II is mounted is moved along the carriage shaft 5. Meanwhile, the apparatus main body 4 is provided with a conveyance roller 8 as a conveyance unit, and a recording sheet S that is a recording medium such as paper is conveyed by the conveyance roller 8. The conveyance unit that conveys the recording sheet S is not limited to the conveyance roller, and may be a belt, a drum, or the like.

In the recording head 1, a piezoelectric element 300 to be described in detail later (see FIG. 2 and the like) is used as a piezoelectric actuator apparatus. Deterioration of various characteristics (durability, ink ejection characteristics, or the like) in the recording apparatus I can be avoided by using the piezoelectric element 300.

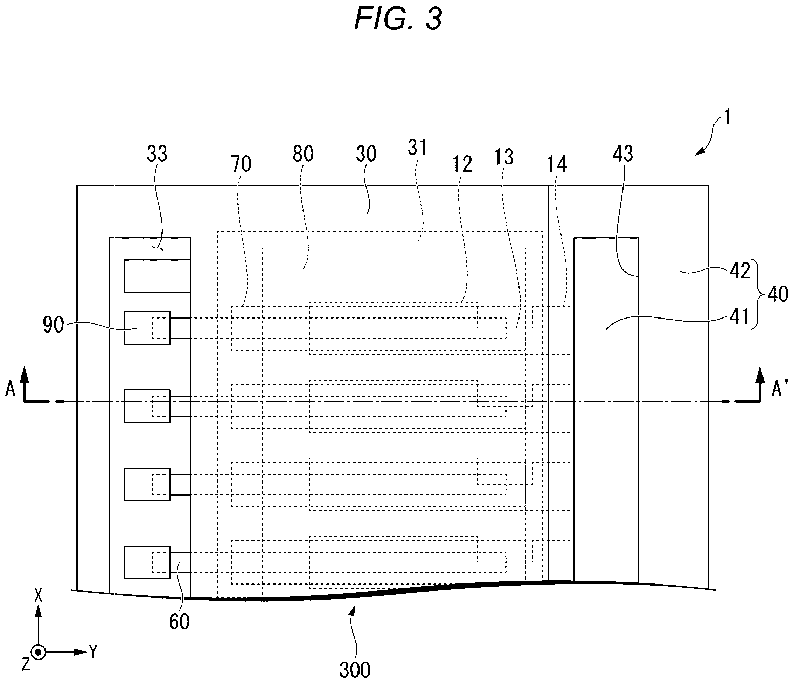

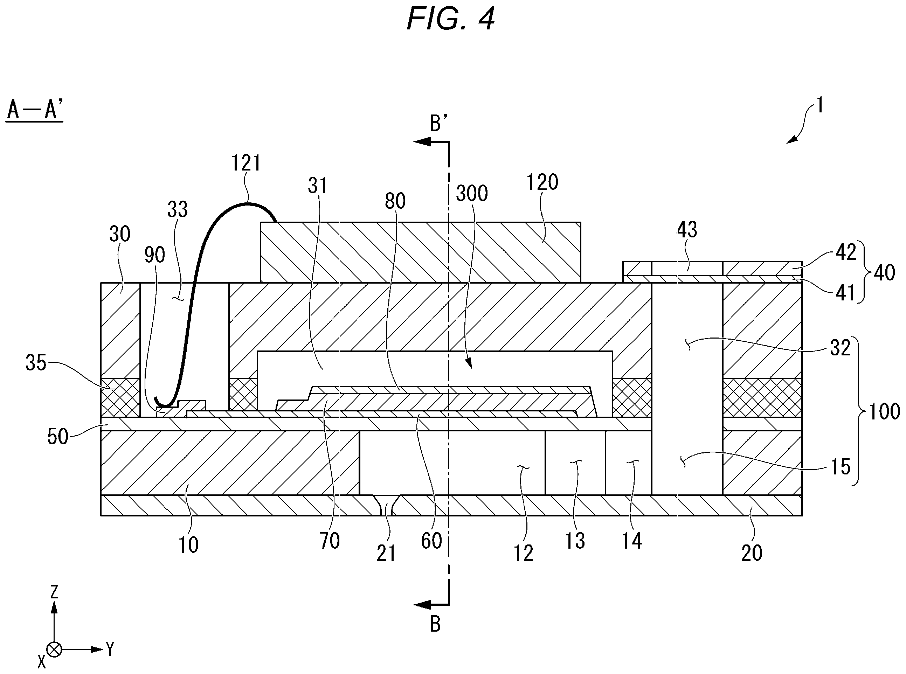

Next, the ink-jet type recording head (recording head) 1 as an example of a liquid ejecting head mounted on a liquid ejecting apparatus will be described with reference to the drawings. FIG. 2 is an exploded perspective view showing a schematic configuration of the recording head 1. FIG. 3 is a plan view showing a schematic configuration of the recording head 1. FIG. 4 is a cross-sectional view taken along a line A-A' in FIG. 3. FIGS. 2 to 4 each show a part of the configuration of the recording head 1, and are omitted as appropriate.

As shown, a flow path forming substrate (substrate) 10 contains silicon (Si). For example, the substrate 10 is a silicon (Si) single crystal substrate.

Pressure generation chambers 12 (hereinafter, also referred to as "pressure chambers 10") partitioned by a plurality of partition walls 11 are formed in the substrate 10. The pressure chambers 12 are arranged in parallel along a direction (+X direction) in which a plurality of nozzle openings 21 that discharge ink of the same color are arranged side by side.

In the substrate 10, an ink supply path 13 and a communication path 14 are formed on one end side (+Y direction side) of the pressure chamber 12. The ink supply path 13 is configured such that an area of an opening on the one end side of the pressure chamber 12 is small. The communication path 14 has substantially the same width as the pressure chamber 12 in a +X direction. A communication portion 15 is formed outward of (+Y direction side) the communication path 14. The communication portion 15 constitutes a part of a manifold 100. The manifold 100 serves as a common ink chamber for the pressure chambers 12. In this way, a liquid flow path including the pressure chamber 12, the ink supply path 13, the communication path 14, and the communication portion 15 is formed in the substrate 10.

A nozzle plate 20 made of, for example, SUS, is joined to one surface (surface on a -Z direction side) of the substrate 10. In the nozzle plate 20, the nozzle openings 21 are arranged side by side along the +X direction. The nozzle openings 21 communicate with the pressure chambers 12. The nozzle plate 20 can be joined to the substrate 10 by an adhesive, a thermal welding film, or the like.

A vibration plate 50 is formed on the other surface (surface on a +Z direction side) of the substrate 10. The vibration plate 50 is made of silicon oxide, for example, silicon dioxide ($SiO_2$).

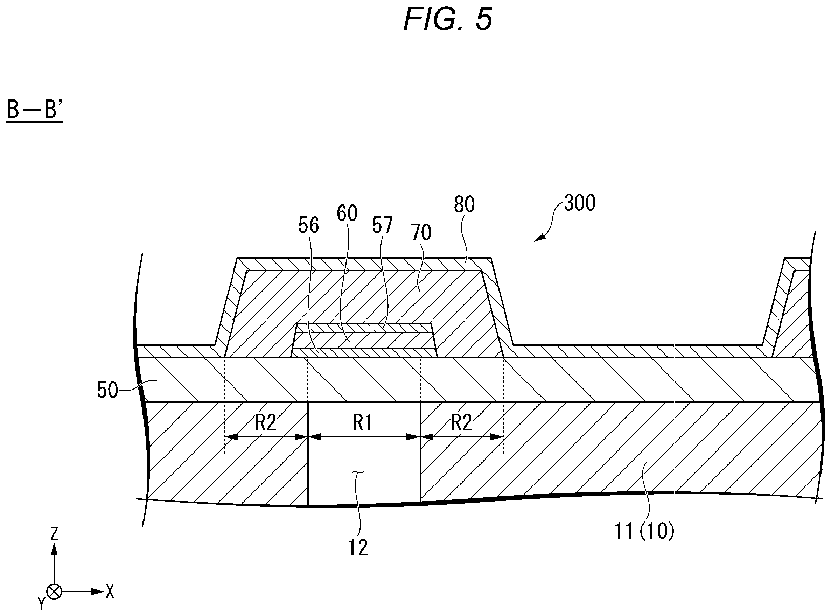

The vibration plate 50 may not be a member separate from the substrate 10. For example, a part of a surface layer (including a surface) on a +Z direction side of the substrate 10 made of silicon may be transformed into silicon oxide by thermal oxidation, and then used as the vibration plate 50. Although FIG. 5 to be described later shows an example in which the vibration plate 50 is laminated on the other surface (surface on the +Z direction side) side of the substrate 10, the substrate 10 and the vibration plate 50 may be integrated.

A first electrode 60, a seed layer (orientation control layer) 57, a piezoelectric layer 70, and a second electrode 80 are formed on the vibration plate 50. A lead electrode 90 is coupled to one end portion side (side opposite from the communication path 14) of the first electrode 60.

Configurations, materials, and the like of the first electrode 60, the seed layer (orientation control layer) 57, the piezoelectric layer 70, and the second electrode 80 will be described in detail later.

In the embodiment, the vibration plate 50 and the first electrode 60 are displaced by displacement of the piezoelectric layer 70 having electromechanical conversion characteristics. That is, the vibration plate 50 and the first electrode 60 substantially function as a vibration plate. However, in reality, since the second electrode 80 is also displaced by the displacement of the piezoelectric layer 70, a region where the vibration plate 50, the first electrode 60, the piezoelectric layer 70, and the second electrode 80 are sequentially laminated functions as a movable portion (also referred to as a vibration portion) of the piezoelectric element 300. In the present specification, in the vibration plate 50, a region functioning as a vibration portion, that is, a region forming a part of a wall surface of the pressure chamber 12 is referred to as a "first region R1".

On the substrate 10 (vibration plate 50) on which the piezoelectric element 300 is formed, the protective substrate 30 is joined by an adhesive 35. The protective substrate 30 has a manifold portion 32. The manifold portion 32 constitutes at least a part of the manifold 100. The manifold portion 32 according to the embodiment penetrates the protective substrate 30 in a thickness direction (Z direction), and is further formed over a width direction (+X direction) of the pressure chamber 12. The manifold portion 32 communicates with the communication portion 15 of the substrate 10. With this configuration, the manifold 100 serving as the common ink chamber for the pressure chambers 12 is formed.

In the protective substrate 30, a piezoelectric element holding portion 31 is formed in a region including the piezoelectric element 300. The piezoelectric element holding portion 31 has a space that does not hinder movement of the piezoelectric element 300. This space may or may not be sealed. The protective substrate 30 has a through hole 33 penetrating the protective substrate 30 in the thickness direction (Z direction). An end portion of the lead electrode 90 is exposed to the through hole 33.

Examples of a material of the protective substrate 30 include Si, SOI, glass, a ceramic material, a metal, and a resin, but more preferably the protective substrate 30 is formed of a material having substantially the same coefficient of thermal expansion as the substrate 10.

A drive circuit 120 functioning as a signal processing unit is fixed on the protective substrate 30. For example, a circuit board or a semiconductor integrated circuit (IC) can be used as the drive circuit 120. The drive circuit 120 and the lead electrode 90 are electrically coupled to each other via a coupling wiring 121 formed of a conductive wire such as a bonding wire inserted through the through hole 33. The drive circuit 120 can be electrically coupled to a printer controller 200 (see FIG. 1). The drive circuit 120 functions as a control unit for the piezoelectric actuator apparatus (piezoelectric element 300).

A compliance substrate 40 including a sealing film 41 and a fixing plate 42 is joined onto the protective substrate 30. The sealing film 41 may be made of a material having low rigidity, and the fixing plate 42 may be made of a hard material such as metal. A region in the fixing plate 42 facing the manifold 100 is an opening 43 completely removed in the thickness direction (Z direction). One surface (surface on the +Z direction side) of the manifold 100 is sealed only by the sealing film 41 having flexibility.

The recording head 1 discharges ink droplets by the following operation.

First, ink is taken in from an ink introduction port coupled to an external ink supply unit (not shown), and the inside from the manifold 100 to the nozzle opening 21 is filled with the ink. Thereafter, according to a recording signal from the drive circuit 120, a voltage is applied between the first electrode 60 and the second electrode 80 corresponding to the pressure chambers 12, and the piezoelectric element 300 is deformed in a bending manner. Accordingly, a pressure in each pressure chamber 12 is increased, and the ink droplets are discharged from the nozzle opening 21.

Piezoelectric Element

Next, a configuration of the piezoelectric element 300 used as the piezoelectric actuator apparatus of the recording head 1 will be described in detail with reference to the drawings. FIG. 5 is an enlarged cross-sectional view taken along a line B-B' in FIG. 4.

As shown in FIG. 5, the piezoelectric element 300 includes the substrate 10, the vibration plate 50 formed on the substrate 10, the first electrode 60 formed on the vibration plate 50, the piezoelectric layer 70 formed on the first electrode 60 and containing potassium, sodium, and niobium, and the second electrode 80 formed on the piezoelectric layer 70.

The substrate 10 has pressure chambers 12 partitioned by the plurality of partition walls 11. With such a configuration, the movable portion of the piezoelectric element 300 is formed.

A vibration plate 50 is formed on the other surface (surface on a +Z direction side) of the substrate 10. The vibration plate 50 is made of silicon oxide, for example, silicon dioxide ($SiO_2$).

A thickness of the vibration plate 50 is, for example, 200 nm or more and 10000 nm or less.

A vibration plate of a piezoelectric element in the related art often has a lamination structure including a silicon oxide film and a zirconium oxide ($ZrO_2$) film laminated thereon. However, in the recording head 1 according to the embodiment, a silicon oxide film is adopted as the vibration plate 50, and the first electrode 60 is provided on the silicon oxide film. That is, the recording head 1 according to the embodiment does not use the zirconium oxide film as the vibration plate. Accordingly, a rigidity of the vibration plate 50 can be reduced, and a displacement amount of the vibration plate 50 can be increased even in a KNN-based piezoelectric layer having a relatively low piezoelectric constant.

On the other hand, when the zirconium oxide film is simply omitted as the vibration plate, elements of the piezoelectric layer are excessively diffused toward the vibration plate, and a compositional balance of the entire piezoelectric layer may be lost. Further, when an amount of diffusion elements in the vibration plate increases, adhesion between the vibration plate and the piezoelectric layer or adhesion between the vibration plate and the first electrode layer decreases, and the layer may peel off.

Therefore, in the embodiment, the vibration plate 50 is a single layer that is a layer made of silicon oxide. When a material of the vibration plate 50 is a material other than silicon oxide, element diffusion from the piezoelectric layer 70 may not be sufficiently prevented. Therefore, the vibration plate 50 is made of silicon oxide.

In this way, in the embodiment, diffusion of potassium, sodium, or the like from the piezoelectric layer 70 toward the vibration plate 50 can be further prevented using the vibration plate 50 made of silicon oxide. Specifically, in secondary ion mass spectrometry (SIMS analysis) on the vibration plate 50 and the piezoelectric layer 70, an intensity of potassium in the vibration plate 50 is lower than an intensity of potassium in the piezoelectric layer 70, and an intensity of sodium in the vibration plate 50 is lower than an intensity of sodium in the piezoelectric layer 70. As used herein, the "intensity" in the secondary ion mass spectrometry means an average intensity in each element.

As described above, in order to increase the displacement amount of the vibration plate 50 while ensuring adhesion between the vibration plate 50 and the piezoelectric layer 70, it is effective to prevent diffusion of potassium, sodium, or the like toward the vibration plate 50 while reducing the rigidity of the entire vibration plate 50 by forming the vibration plate 50 as the single layer that is the silicon oxide layer (that is, omitting the $ZrO_2$ film in the related art). Therefore, in the embodiment, a diffusion amount of potassium and sodium in the vibration plate 50 is defined by the intensity (SIMS intensity) obtained by SIMS analysis as described above. That is, by setting intensities of potassium and sodium in the vibration plate 50 to be lower than intensities of potassium and sodium in the piezoelectric layer 70, the displacement amount of the vibration plate 50 can be increased without reducing a piezoelectric constant of the piezoelectric layer 70.

As a specific method for reducing the amount of potassium and sodium diffused toward the vibration plate 50, it is effective to optimize the material of the seed layer 57, the conditions at the time of forming the piezoelectric layer 70, and the like, in addition to the method of forming the vibration plate 50 into a single layer of a silicon oxide layer.

A material of the first electrode 60 is preferably a noble metal such as platinum (Pt) or iridium (Ir) or an oxide thereof. The material of the first electrode 60 may be any conductive material. A thickness of the first electrode 60 is not particularly limited, and is, for example, 10 nm to 200 nm.

The first electrode 60 may be formed via an adhesion layer 56. In this case, the adhesion layer is, for example, a layer containing titanium oxide ($TiO_X$). In addition, for example, a layer containing titanium (Ti) or a layer containing silicon nitride (SiN) may be used as the adhesion layer 56. The adhesion layer has a function of improving adhesion between the piezoelectric layer 70 and the vibration plate 50. The adhesion layer 56 also has a function as a stopper that reduces excessive penetration of potassium and sodium, which are elements of the piezoelectric layer 70, into the substrate 10 through the first electrode 60 when forming the piezoelectric layer 70 to be described later. The adhesion layer may be omitted.

An intensity of potassium in the first electrode 60 may be lower than the intensity of potassium in the vibration plate 50, and an intensity of sodium in the first electrode 60 may be lower than the intensity of sodium in the vibration plate 50.

The first electrode 60 may be provided for each pressure chamber 12. That is, the first electrode 60 may be formed as an individual electrode independent for each pressure chamber 12. In this case, the first electrode 60 is smaller than a width of the pressure chamber 12 in a $\pm X$ direction.

The first electrode 60 has a width larger than a width of the pressure chamber 12 in a $\pm Y$ direction. That is, in the $\pm Y$ direction, both end portions of the first electrode 60 are formed up to the outside of a region (first region R1) of the vibration plate 50 facing the pressure chamber 12. In other words, the first electrode 60 covers the first region R1 as viewed from a thickness direction ($\pm Z$ direction) of the piezoelectric layer 70.

By providing the first electrode 60 so as to cover the first region R1 that is a movable region of the vibration plate 50, it is possible to prevent the diffusion of potassium, sodium, or the like constituting the piezoelectric layer 70 toward the vibration plate 50. When potassium, sodium, or the like is excessively diffused toward the vibration plate 50, the vibration plate 50 may become brittle, and brittle fracture may occur with repeated driving. Therefore, by covering the first region R1 of the vibration plate 50 with the first electrode 60 so as to prevent diffusion of potassium or sodium, a life of the piezoelectric device can be prolonged. A width of the first electrode 60 may be the same as the width of the pressure chamber 12 in the $\pm Y$ direction, and the width of the pressure chamber 12 is preferably wider from a viewpoint of further preventing diffusion of the above elements.

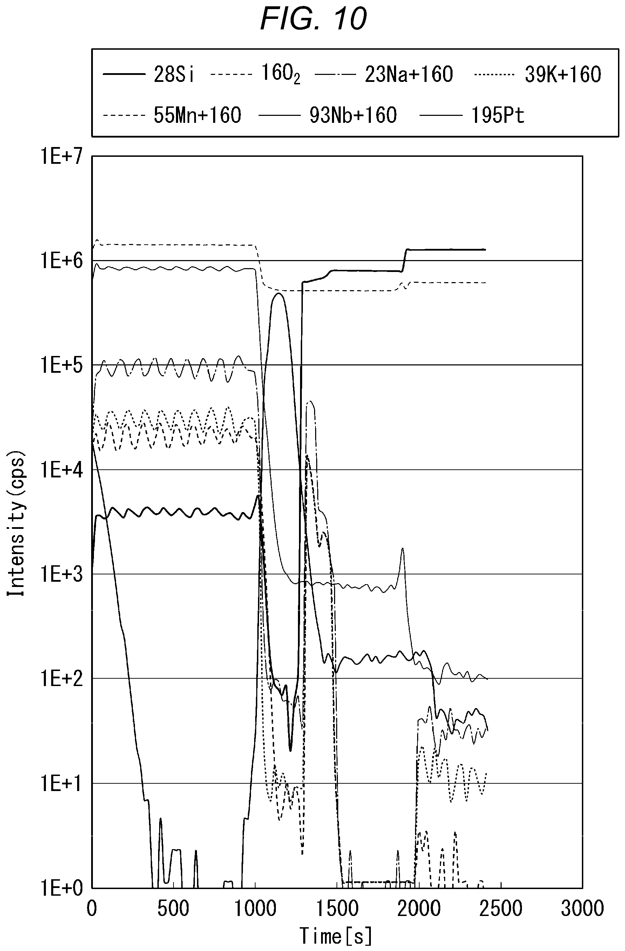

FIG. 10 shows a result of the SIMS analysis on the piezoelectric element according to the embodiment. The SIMS analysis result shown in FIG. 10 is obtained by using the vibration plate 50, the first electrode 60, and the piezoelectric layer 70, and the seed layer is omitted. As shown in FIG. 10, in the vibration plate 50 below the first electrode 60, that is, in the first region R1, it can be seen that the intensity of sodium or potassium increases once in the vicinity of an interface between the first electrode 60 and the vibration plate 50, but drops rapidly thereafter. From this, it can be seen that diffusion of potassium, sodium, or the like toward the first region R1 can be prevented by providing the first electrode 60 so as to cover the first region R1.

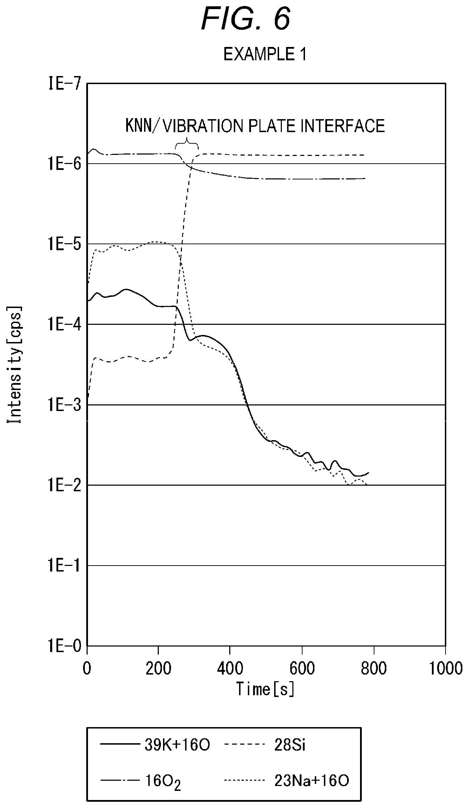

When the first electrode 60 is provided so as to cover the first region R1, an average value of an intensity of potassium in the first region R1 is lower than an average value of an intensity of potassium in a region (second region R2) other than the first region R1, and an average value of an intensity of sodium in the first region R1 is lower than an average value of an intensity of sodium in the second region R2. This is also apparent from a comparison between FIG. 10 and FIG. 6 to be described later (Example 1), and is because diffusion of potassium, sodium, or the like progresses when the piezoelectric layer is present on the vibration plate without the first electrode interposed therebetween as in the second region R2 (corresponding to Example 1). That is, in the first region R1 covered with the first electrode 60, diffusion of potassium or sodium is prevented more than in the second region R2 not covered with the first electrode 60, and thus intensities of potassium and sodium in the first region R1 are lower than intensities of potassium and sodium in the second region R2.

By reducing the intensities of potassium and sodium in the first region R1 that is the movable region in this manner, it is possible to further prevent the first region R1 from becoming brittle and to further prolong the life of the piezoelectric device.

The seed layer (orientation control layer) 57 is provided between the first electrode 60 and the piezoelectric layer 70. When the adhesion layer 56 is formed, the seed layer 57 may be provided on the adhesion layer 56. The seed layer 57 has a function of controlling a crystal orientation of a piezoelectric body constituting the piezoelectric layer 70. That is, by providing the seed layer 57 on the first electrode 60, crystals of the piezoelectric body constituting the piezoelectric layer 70 can be preferentially oriented in a predetermined plane orientation (for example, a (100) plane). By improving the crystal orientation of the piezoelectric layer 70, it is possible to efficiently use domain rotation and improve displacement characteristics of the piezoelectric layer 70.

A thickness of the seed layer 57 is, for example, 1 nm or more and 50 nm or less.

Examples of a material of the seed layer 57 include compounds containing bismuth, iron, titanium, and lead, oxides of lithium and niobium (LiNbO), and zinc oxides (ZnO), among which compounds containing bismuth, iron, titanium, and lead are preferable. By using compounds containing bismuth, iron, titanium, and lead as the material of the seed layer 57, a crystal structure of the KNN-based piezoelectric layer 70 can be further stabilized. That is, by forming the piezoelectric layer 70 using LiNbO as the seed layer 57, stability of potassium or sodium in the piezoelectric layer 70 can be increased, and thus as a result, diffusion of potassium and sodium toward the vibration plate 50 and the substrate 19 can be further prevented. From this viewpoint, the seed layer 57 is also preferably provided between the vibration plate 50 and the piezoelectric layer 70.

The piezoelectric layer 70 is provided between the first electrode 60 and the second electrode 80. The piezoelectric layer 70 is a so-called thin-film piezoelectric body having a thickness of 500 nm or more and 3000 nm or less. Here, the "thin-film piezoelectric body" is a piezoelectric body formed by crystal growth on a substrate. The piezoelectric layer 70 has a width larger than the width of the first electrode 60 in the $\pm X$ direction. The piezoelectric layer 70 has a width larger than a length of the pressure chamber 12 in the $\pm Y$ direction. An end portion of the piezoelectric layer 70 on an ink supply path 13 side (+Y direction side) is formed up to the outside of an end portion of the first electrode 60 on a +Y direction side. That is, the end portion of the first electrode 60 on the +Y direction side is covered with the piezoelectric layer 70. Meanwhile, an end portion of the piezoelectric layer 70 on a lead electrode 90 side (-Y direction side) is inward of (on a +Y direction side of) an end portion of the first electrode 60 on a -Y direction side. That is, the end portion of the first electrode 60 on the -Y direction side is not covered with the piezoelectric layer 70.

The piezoelectric layer 70 is preferably made of polycrystal preferentially oriented in the (100) plane. When the piezoelectric layer 70 is preferentially oriented in the (100) plane in this manner, it is possible to efficiently use domain rotation and improve displacement characteristics.

The expression "preferentially oriented in the (100) plane" includes a case where all crystals of the piezoelectric layer 70 are oriented in the (100) plane and a case where most crystals (50% or more, preferably 80% or more, and more preferably 90% or more crystals) are oriented in the (100) plane.

When the piezoelectric layer 70 is made of polycrystal, a stress in the plane is dispersed and uniform, and thus stress fracture in the piezoelectric element 300 hardly occurs, and reliability of the element is improved.

The piezoelectric layer 70 is formed by a solution method (also referred to as a liquid phase method or a wet method) such as an MOD method or a sol-gel method, or a gas phase method such as sputtering. The piezoelectric layer 70 according to the embodiment is a perovskite-type composite oxide represented by a general formula $ABO_3$ containing potassium (K), sodium (Na), and niobium (Nb). That is, the piezoelectric layer 70 contains a piezoelectric material made of a KNN-based composite oxide represented by the following formula (1).

$$(K_X, Na_{1-X})NbO_3... \qquad (1)$$

$$(0.1 \leq X \leq 0.9)$$

The piezoelectric material constituting the piezoelectric layer 70 is not limited to the composition represented by the formula (1) as long as the piezoelectric material is a KNN-based composite oxide. For example, another metal element (additive) may be contained in an A site or a B site of potassium sodium niobate. Examples of such an additive include manganese (Mn), lithium (Li), barium (Ba), calcium (Ca), strontium (Sr), zirconium (Zr), titanium (Ti), bismuth (Bi), tantalum (Ta), antimony (Sb), iron (Fe), cobalt (Co), silver (Ag), magnesium (Mg), zinc (Zn), and copper (Cu).

One or more additives of this type may be contained. Generally, an amount of the additive is 20% or less, preferably 15% or less, and more preferably 10% or less with respect to a total amount of elements as main components. When the additive is used, it is easy to improve various characteristics and diversify the configuration and function, but KNN is preferably present at an amount of more than 80% from a viewpoint of exhibiting characteristics derived from KNN. Even in a case of a composite oxide containing these other elements, the composite oxide preferably has an ABO ternary perovskite structure.

In the present specification, the "perovskite-type composite oxide containing K, Na, and Nb" is a "composite oxide having an ABO ternary perovskite structure containing K, Na, and Nb", but is not limited to the composite oxide having an ABO ternary perovskite structure containing K, Na, and Nb. That is, in the present specification, the "perovskite-type composite oxide containing K, Na, and Nb" includes a piezoelectric material represented as a crystal containing a composite oxide having an ABO ternary perovskite structure containing K, Na, and Nb (for example, the KNN-based composite oxide exemplified above) and another composite oxide having an ABO ternary perovskite structure.

The other composite oxide is not limited within the scope of the embodiment, and is preferably a lead-free piezoelectric material with a lead (Pb) content of 0.1 at% or less. The other composite oxide is more preferably a lead-free piezoelectric material in which a content of lead (Pb) and bismuth (Bi) is 0.1 at% or less. According to these, the piezoelectric element 300 is excellent in biocompatibility and has less environmental impact.

The second electrode 80 is provided continuously on the piezoelectric layer 70 and the vibration plate 50 in the +X direction. That is, the second electrode 80 is formed as a common electrode common to a plurality of piezoelectric layers 70. In the embodiment, the first electrode 60 constitutes an individual electrode independently provided corresponding to the pressure chamber 12, and the second electrode 80 constitutes a common electrode continuously provided along a direction in which the pressure chambers 12 are arranged side by side. Alternatively, the first electrode 60 may constitute a common electrode, and the second electrode 80 may constitute an individual electrode.

A material of the second electrode 80 is preferably a noble metal such as platinum (Pt) or iridium (Ir) or an oxide thereof. The material of the second electrode 80 may be any conductive material. The material of the first electrode 60 and the material of the second electrode 80 may be the same or different.

According to the piezoelectric element application device (recording head 1) according to the first embodiment described above, an displacement amount of the vibration plate 50 can be improved while ensuring adhesion between the vibration plate 50 and the piezoelectric layer 70 by using the vibration plate 50 made of silicon oxide and limiting SIMS intensities of potassium and sodium in the vibration plate 50 to be lower than SIMS intensities of potassium and sodium in the piezoelectric layer 70.

Other Embodiments

The ink-jet type recording head has been described as an example of the liquid ejecting head in the first embodiment, but the disclosure is applicable to general liquid ejecting heads, and is also applicable to a liquid ejecting head that ejects liquid other than ink. Examples of other liquid ejecting heads include various recording heads used in an image recording apparatus such as a printer, a color material ejecting head used for manufacturing a color filter such as a liquid crystal display, an electrode material ejecting head used for forming electrodes such as an organic EL display and a field emission display (FED), and a bioorganic material ejecting head used for manufacturing a biochip.

The piezoelectric element 300 described above is not limited to a piezoelectric element mounted on a liquid ejecting head, and can also be applied to a piezoelectric element mounted on another piezoelectric element application device. Examples of the piezoelectric element application device include an ultrasonic device, a motor, a pressure sensor, a pyroelectric element, and a ferroelectric element. The piezoelectric element application device also includes completed bodies using these piezoelectric element application devices, for example, an ejecting apparatus for liquid or the like using an ejecting head for the liquid or the like, an ultrasonic sensor using the ultrasonic device, a robot using the motor as a drive source, an IR sensor using the pyroelectric element, and a ferroelectric memory using the ferroelectric element.

Dimensions (for example, thicknesses), shapes, and the like of the elements described above are all examples, and can be changed without changing the gist of the embodiment.

Method for Manufacturing Piezoelectric Element Application Device

Next, an example of a method for manufacturing the piezoelectric element application device (recording head 1) will be described. A case where the piezoelectric layer 70 is manufactured by a chemical solution method (wet method) will be described hereinafter, but the method for manufacturing the piezoelectric layer 70 is not limited to the wet method and may be a gas phase method.

First, a substrate containing silicon (hereinafter also referred to as a "wafer") is prepared, and the substrate is thermally oxidized, whereby the vibration plate 50 made of silicon dioxide ($SiO_2$) is formed at a surface of the substrate.

Next, the first electrode 60 is formed on the vibration plate 50 by a method (such as sputtering or vapor deposition) in the related art. The first electrode 60 may be formed via the adhesion layer 56 (for example, titanium oxide). When forming the adhesion layer 56, the adhesion layer 56 and the first electrode 60 may be simultaneously patterned. The adhesion layer 56 and the first electrode 60 can be patterned by, for example, dry etching such as reactive ion etching (RIE) or ion milling, or wet etching using an etchant. Shapes of the adhesion layer 56 and the first electrode 60 in patterning are not particularly limited.

Next, the seed layer 57 is formed so as to cover the patterned first electrode 60 and the vibration plate 50. The seed layer 57 can be formed by, for example, a chemical solution method (wet method) in which a solution containing a metal complex (precursor solution) is applied and dried, and then fired at a high temperature to obtain a metal oxide. Examples of the material of the seed layer 57 include compounds containing bismuth, iron, titanium, and lead, oxides of lithium and niobium (LiNbO), and zinc oxides (ZnO).

Next, a plurality of piezoelectric films are formed on the seed layer 57.

The piezoelectric layer 70 is formed of the plurality of piezoelectric films. The piezoelectric layer 70 can be formed by the solution method (chemical solution method) such as the MOD method or the sol-gel method. By forming the piezoelectric layer 70 by the solution method, productivity of the piezoelectric layer 70 can be improved. The piezoelectric layer 70 formed by the solution method is formed by repeating a series of steps from a step of applying a precursor solution (application step) to a step of firing a precursor film (firing step) a plurality of times.

**EP 4 429 445 B1**

A specific procedure for forming the piezoelectric layer 70 by the solution method is, for example, as follows.

First, a precursor solution containing a predetermined metal complex is prepared. The precursor solution is obtained by dissolving or dispersing, in an organic solvent, the metal complex capable of forming a composite oxide containing K, Na, and Nb by firing. At this time, a metal complex containing an additive such as Mn may be further mixed.

Examples of a metal complex containing K include potassium 2-ethylhexanoate and potassium acetate. Examples of a metal complex containing Na include sodium 2-ethylhexanoate and sodium acetate. Examples of a metal complex containing Nb include niobium 2-ethylhexanoate and niobium pentaethoxylate. When Mn is added as the additive, examples of a metal complex containing Mn include manganese 2-ethylhexanoate. At this time, two or more types of metal complexes may be used in combination. For example, potassium 2-ethylhexanoate and potassium acetate may be used in combination as the metal complex containing K. Examples of the solvent include 2-n-butoxyethanol, n-octane, and a mixed solvent thereof. The precursor solution may contain an additive that stabilizes dispersion of the metal complex containing K, Na, and Nb. Examples of such an additive include 2-ethylhexanoic acid.

Then, the precursor solution is applied onto the vibration plate 50 on which the first electrode 60 is formed to form the precursor film (application step).

Next, the precursor film is heated to a predetermined temperature, for example, about 150°C to 250°C, and dried for a certain period of time (drying step). An average temperature increase rate in the drying step is preferably 50°C to 100°C/s. By firing the piezoelectric film at such a temperature increase rate using the solution method, the piezoelectric layer 70 that is not a pseudocubic crystal can be formed.

Next, the dried precursor film is heated to a predetermined temperature, for example, 300°C to 450°C, and is held at this temperature for a certain period of time to be degreased (degreasing step).

A heating temperature in a degreasing step is preferably 450°C or lower from a viewpoint of preventing diffusion of elements in the precursor film toward the vibration plate. More preferably, the heating temperature is 400°C or lower. However, when the heating temperature in the degreasing step is excessively low, an orientation abnormality due to residual C (carbon) may occur. Therefore, the heating temperature is preferably 350°C or higher.

A heating time in the degreasing step is preferably ten minutes or less from the viewpoint of preventing diffusion of the elements in the precursor film toward the vibration plate. More preferably, the heating time is five minutes or less. However, when the heating time in the degreasing step is excessively short, a degreasing failure may occur. Therefore, the heating time is preferably two minutes or more.

Finally, the degreased precursor film is heated to a relatively high temperature, for example, about 650°C to 750°C, and is held at this temperature for a certain period of time to be crystallized. Accordingly, the piezoelectric film is completed (firing step).

A heating temperature in a firing step is preferably 750°C or lower from the viewpoint of preventing diffusion of the elements in the precursor film toward the vibration plate. More preferably, the heating temperature is 700°C or lower. However, when the heating temperature in the firing step is excessively low, firing and crystallization may be insufficient. Therefore, the heating temperature is preferably 650°C or higher.

A heating time in the firing step is preferably ten minutes or less from the viewpoint of preventing diffusion of the elements in the precursor film toward the substrate. More preferably, the heating time is five minutes or less. However, when the heating time in the firing step is excessively short, a firing failure may occur and crystallization may be insufficient. Therefore, the heating time is preferably two minutes or more.

Examples of a heating apparatus used in the drying step, the degreasing step, and the firing step include a rapid thermal annealing (RTA) apparatus and a hot plate, which perform heating by irradiation with an infrared ray lamp. The above steps are repeated a plurality of times to form the piezoelectric layer 70 including the plurality of piezoelectric films. In a series of steps from the application step to the firing step, the firing step may be performed after repeating the steps from the application step to the degreasing step a plurality of times.

Before and after the second electrode 80 is formed on the piezoelectric layer 70, reheat treatment (post-annealing) may be performed in a temperature range of 600°C to 800°C as necessary. By performing post-annealing in this manner, a good interface between the piezoelectric layer 70 and the first electrode 60 and a good interface between the piezoelectric layer 70 and the second electrode 80 can be formed, and crystallinity of the piezoelectric layer 70 can be improved.

After the firing step, the piezoelectric layer 70 including the plurality of piezoelectric films is patterned into a shape as shown in FIG. 5. Patterning can be performed by dry etching such as reactive ion etching or ion milling, or wet etching using an etchant.

Thereafter, the second electrode 80 is formed on the piezoelectric layer 70. The second electrode 80 can be formed by the same method as the first electrode 60.

The piezoelectric element 300 including the first electrode 60, the piezoelectric layer 70, and the second electrode 80 is manufactured through the above steps.

Thereafter, the protective substrate 30 is provided on the substrate 10 (vibration plate 50) on which the piezoelectric element 300 is formed by a method (see FIG. 2) in the related art, and further, in addition to each pressure chamber 12 corresponding to the piezoelectric element 300, elements such as the ink supply path 13, the communication path 14, and the communication portion 15 (see FIG. 2) are formed.

An assembly of chips of the piezoelectric element application device (recording head 1) is completed through the above steps. By dividing the assembly into individual chips, the piezoelectric element application device (recording head 1) is obtained.

Examples

Hereinafter, the disclosure will be described in more detail with reference to examples, but the disclosure is not limited to the examples.

Example 1

First, a surface of a silicon substrate (15.24 cm (six inches)) to be a substrate was thermally oxidized to form a vibration plate made of silicon dioxide on the substrate, thereby obtaining a base substrate.

Next, a piezoelectric layer was formed on the base substrate by the following procedure.

First, a precursor solution containing potassium 2-ethylhexanoate, sodium 2-ethylhexanoate, lithium 2-ethylhexanoate, niobium 2-ethylhexanoate, and manganese 2-ethylhexanoate was applied onto the base substrate by spin coating to form a precursor film (application step).

Thereafter, the precursor film was dried at 180°C (drying step), and then degreased at 380°C for three minutes (degreasing step).

Next, the degreased precursor film was subjected to heat treatment at 700°C for three minutes using rapid thermal annealing (RTA) to form a piezoelectric film (firing step). Steps from the application step to the firing step were repeated a plurality of times until a crack was confirmed, and a KNN-based piezoelectric layer including a plurality of piezoelectric films was fabricated.

Example 2

A piezoelectric layer was formed on a substrate without performing thermal oxidation in preparation of the base substrate. Other conditions were the same as those in Example 1. A silicon dioxide film formed by partially oxidizing of a surface layer of the substrate by heat treatment in a firing step or the like was used as a vibration plate.

Comparative Example 1

A Zr film was formed on a substrate by sputtering, and a surface of the Zr film was thermally oxidized to form a vibration plate made of zirconium dioxide ($ZrO_2$) on the substrate, thereby obtaining a base substrate. Other conditions were the same as those in Example 1.

Comparative Example 2

This example was the same as Example 1 except that a material of the piezoelectric layer was an AlN film.

For the above-described examples and comparative examples, the following element diffusion and delamination were confirmed.

Confirmation of Element Diffusion

Element diffusion toward the vibration plate of the piezoelectric layer was confirmed using a secondary ion mass spectrometry (SIMS) apparatus ("IMS-7f sector type" manufactured by CAMECA). Primary ions were raster-scanned with 15 keV Cs+ at a beam current of 10 nA in a 100 $\mu$m square, and negative secondary ions were detected from a center of 33 $\mu$m$\phi$. An electron gun was used to prevent charge-up.

Confirmation of Delamination

Presence or absence of delamination was determined by observation using a scanning electron microscope (SEM). Specifically, a state of delamination was confirmed by observation with a Hitachi scanning electron microscope S-4700 at an acceleration voltage of 10 kV and a magnification of 100 k.

Test Results

In Comparative Example 2, since AIN was used as a material of the piezoelectric layer, a large amount of Al was diffused to a substrate side, and as a result, delamination occurred between the piezoelectric layer and the substrate.

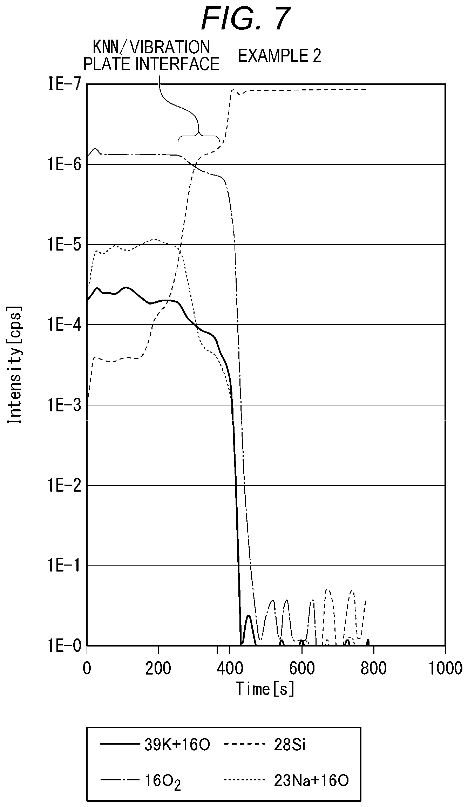

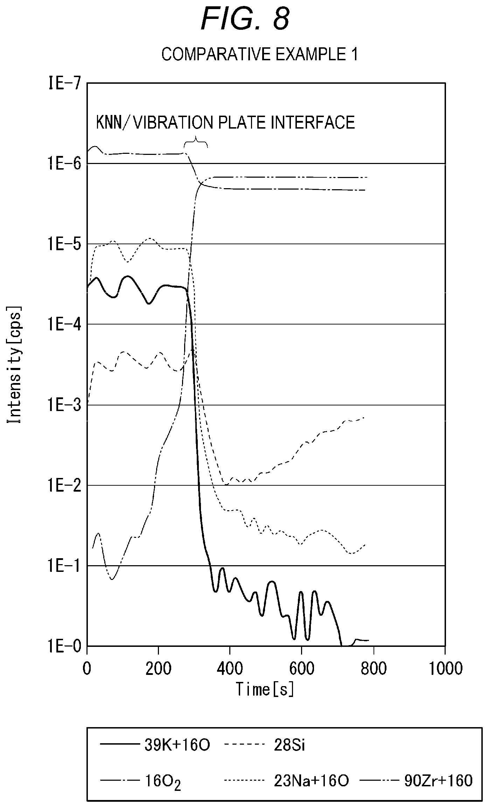

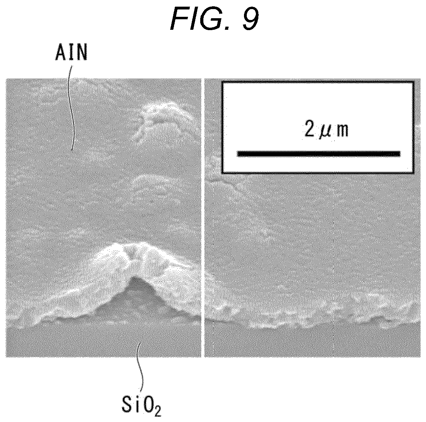

FIG. 6 is an analysis result of Example 1 using a $SiO_2$ film as the vibration plate 50, FIG. 7 is an analysis result of Example 2 using a $SiO_2$ thin film as the vibration plate 50, and FIG. 8 is an analysis result of Comparative Example 1 using a $ZrO_2$ film as the vibration plate. FIGS. 6 to 9 all show results of analysis from the piezoelectric layer toward the substrate, and show analysis results toward the substrate together with elapse of an analysis time (horizontal axis).

As shown in FIGS. 6 and 7, when only a film made of $SiO_2$ was used as the vibration plate, concentrations of potassium (K) and sodium (Na) constituting the piezoelectric layer tended to gradually decrease without dropping sharply even after passing an interface with the piezoelectric layer. From this, when the $SiO_2$ film is used as the vibration plate, it is considered that elements of the piezoelectric layer are slightly diffused to the vibration plate side. However, in Examples 1 and 2, no delamination occurred between the piezoelectric layer and the vibration plate, and adhesion was ensured.

As shown in FIG. 8, when a laminated film of a $SiO_2$ film and a $ZrO_2$ film is used as the vibration plate, concentrations of potassium (K) and sodium (Na) constituting the piezoelectric layer drops sharply, no elemental diffusion toward the vibration plate was confirmed and no delamination was confirmed, but it is considered that a displacement amount is lower than those in Examples 1 and 2 due to an increase in a rigidity of the entire vibration plate.

Accordingly, in order to ensure adhesion between the piezoelectric layer and the vibration plate and increase the displacement amount by reducing the rigidity of the vibration plate, it can be seen that it is preferable to use a film made of $SiO_2$ as the vibration plate.

**Claims**

1. A piezoelectric element application device (1) comprising:

   a vibration plate (50) made of silicon oxide;
   a first electrode (60) formed above the vibration plate;
   a seed layer (57) formed on the first electrode and the vibration plate;
   a piezoelectric layer (70) formed on the seed layer and containing potassium, sodium, and niobium; and
   a second electrode (80) formed on the piezoelectric layer, wherein the vibration plate further contains potassium and sodium,
   in secondary ion mass spectrometry on the vibration plate and the piezoelectric layer,

      an intensity of potassium in the vibration plate is lower than an intensity of potassium in the piezoelectric layer, and
      an intensity of sodium in the vibration plate is lower than an intensity of sodium in the piezoelectric layer,

   the vibration plate is formed on a silicon substrate (10), and
   the silicon substrate has a pressure chamber (12),
   **characterised in that,** when a region constituting a part of a wall surface of the pressure chamber in the vibration plate is defined as a first region (R1), the first electrode covers the first region as viewed from a thickness direction (Z) of the piezoelectric layer, and,
   in secondary ion mass spectrometry on the first region and a second region (R2) other than the first region in the vibration plate,

      an average value of an intensity of potassium in the first region is lower than an average value of an intensity of potassium in the second region, and
      an average value of an intensity of sodium in the first region is lower than an average value of an intensity of sodium in the second region.

2. The piezoelectric element application device (1) according to claim 1, wherein a layer (56) containing titanium oxide is provided between the vibration plate (50) and the first electrode (60).

3. The piezoelectric element application device (1) according to claim 1, wherein the seed layer (57) contains bismuth, iron, titanium, and lead.

4. The piezoelectric element application device (1) according to claim 1, wherein

the intensity of potassium in the vibration plate (50) is higher than an intensity of potassium in the first electrode (60), and the intensity of sodium in the vibration plate is higher than an intensity of sodium in the first electrode.

**Patentansprüche**

1. Anwendungsvorrichtung (1) mit piezoelektrischem Element, umfassend:

   eine Vibrationsplatte (50), die aus Siliziumoxid hergestellt ist;
   eine erste Elektrode (60), die über der Vibrationsplatte gebildet ist;
   eine Seed-Schicht (57), die auf der ersten Elektrode und der Vibrationsplatte gebildet ist;
   eine piezoelektrische Schicht (70), die auf der Seed-Schicht gebildet ist und Kalium, Natrium und Niob enthält; und
   eine zweite Elektrode (80), die auf der piezoelektrischen Schicht gebildet ist,
   wobei die Vibrationsplatte ferner Kalium und Natrium enthält,
   in einer sekundären Ionenmassenspektrometrie auf der Vibrationsplatte und der piezoelektrischen Schicht
   eine Intensität von Kalium in der Vibrationsplatte niedriger ist als eine Intensität von Kalium in der piezoelektrischen Schicht und
   eine Intensität von Natrium in der Vibrationsplatte niedriger ist als eine Intensität von Natrium in der piezoelektrischen Schicht,
   die Vibrationsplatte auf einem Siliziumsubstrat (10) gebildet ist und
   das Siliziumsubstrat eine Druckkammer (12) aufweist,
   **dadurch gekennzeichnet, dass,** wenn
   eine Region, die einen Teil einer Wandfläche der Druckkammer in der Vibrationsplatte bildet, als eine erste Region (R1) definiert ist, die erste Elektrode die erste Region, betrachtet aus einer Dickenrichtung (Z) der piezoelektrischen Schicht, bedeckt, und
   in einer sekundären Ionenmassenspektrometrie auf der ersten Region und einer zweiten Region (R2), die nicht die erste Region in der Vibrationsplatte ist,
   ein Durchschnittswert einer Intensität von Kalium in der ersten Region niedriger ist als ein Durchschnittswert einer Intensität von Kalium in der zweiten Region und
   ein Durchschnittswert einer Intensität von Natrium in der ersten Region niedriger ist als ein Durchschnittswert einer Intensität von Natrium in der zweiten Region.

2. Anwendungsvorrichtung (1) mit piezoelektrischem Element nach Anspruch 1, wobei
   eine Schicht (56), die Titanoxid enthält, zwischen der Vibrationsplatte (50) und der ersten Elektrode (60) bereitgestellt ist.

3. Anwendungsvorrichtung (1) mit piezoelektrischem Element nach Anspruch 1, wobei
   die Seed-Schicht (57) Wismut, Eisen, Titan und Blei enthält.

4. Anwendungsvorrichtung (1) mit piezoelektrischem Element nach Anspruch 1, wobei
   die Intensität von Kalium in der Vibrationsplatte (50) höher ist als eine Intensität von Kalium in der ersten Elektrode (60) und die Intensität von Natrium in der Vibrationsplatte höher ist als eine Intensität von Natrium in der ersten Elektrode.

**Revendications**

1. Dispositif d'application d'élément piézoélectrique (1), comprenant :

   une plaque vibrante (50) constituée d'oxyde de silicium ;
   une première électrode (60) formée au-dessus de la plaque vibrante ;
   une couche d'ensemencement (57) formée sur la première électrode et la plaque vibrante ;
   une couche piézoélectrique (70) formée sur la couche d'ensemencement et contenant du potassium, du sodium et du niobium ; et
   une deuxième électrode (80) formée sur la couche piézoélectrique,
   dans lequel la plaque vibrante contient en outre du potassium et du sodium,
   dans une spectrométrie de masse ionique secondaire,
   une intensité du potassium dans la plaque vibrante est inférieure à une intensité du potassium dans la couche piézoélectrique, et

une intensité du sodium dans la plaque vibrante est inférieure à une intensité du sodium dans la couche piézoélectrique,

la plaque vibrante est formée sur un substrat de silicium (10), et

le substrat de silicium comporte une chambre de pression (12),

**caractérisé en ce que**

lorsqu'une région constituant une partie d'une surface de paroi de la chambre de pression dans la plaque vibrante est définie comme une première région (R1), la première électrode recouvre la première région, vue depuis une direction d'épaisseur (Z) de la couche piézoélectrique, et

dans une spectrométrie de masse ionique secondaire sur la première région et une deuxième région (R2) différente de la première région dans la plaque vibrante,

une valeur moyenne d'une intensité du potassium dans la première région est inférieure à une valeur moyenne d'une intensité du potassium dans la deuxième région, et

une valeur moyenne d'une intensité du sodium dans la première région est inférieure à une valeur moyenne d'une intensité du sodium dans la deuxième région.

2. Dispositif d'application d'élément piézoélectrique (1) selon la revendication 1, dans lequel une couche (56) contenant de l'oxyde de titane est disposée entre la plaque vibrante (50) et la première électrode (60).

3. Dispositif d'application d'élément piézoélectrique (1) selon la revendication 1, dans lequel
la couche d'ensemencement (57) contient du bismuth, du fer, du titane et du plomb.

4. Dispositif d'application d'élément piézoélectrique (1) selon la revendication 1, dans lequel
l'intensité du potassium dans la plaque vibrante (50) est supérieure à une intensité du potassium dans la première électrode (60), et l'intensité du sodium dans la plaque vibrante est supérieure à une intensité du sodium dans la première électrode.

# FIG. 1

EP 4 429 445 B1

# FIG. 2

FIG. 3

EP 4 429 445 B1

*FIG. 4*

A—A'

EP 4 429 445 B1

*FIG. 5*

B—B'

EP 4 429 445 B1

## FIG. 6

### EXAMPLE 1

## FIG. 7

# FIG. 8

### COMPARATIVE EXAMPLE 1

## FIG. 9

AIN

2 μm

SiO₂

## FIG. 10

**EP 4 429 445 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2018133458 A

- JP 2016192511 A